# EUROPÄISCHE PATENTSCHRIFT

(11) **EP 3 827 488 B1**
(45) Veröffentlichungstag und Bekanntmachung des Hinweises auf die Patenterteilung: **13.12.2023**
(21) Anmeldenummer: 19744664.4
(22) Anmeldetag: 22.07.2019
(51) Int. Cl.: H01S 3/09

(54) **STRAHLUNGSQUELLE UND VORRICHTUNG ZUR RÜCKKOPPLUNG VON EMITTIERTER STRAHLUNG IN EINE LASERQUELLE**
RADIATION SOURCE AND DEVICE FOR FEEDING BACK EMITTED RADIATION TO A LASER SOURCE
SOURCE DE RAYONNEMENT ET DISPOSITIF POUR RÉINJECTER UN RAYONNEMENT ÉMIS DANS UNE SOURCE LASER

(30) Priorität: 23.07.2018 DE 102018212224
(43) Veröffentlichungstag der Anmeldung: 02.06.2021
(73) Patentinhaber: Carl Zeiss SMT GmbH, 73447 Oberkochen (DE)
(72) Erfinder: DINGER, Udo, 73447 Oberkochen (DE)
(74) Vertreter: Rau, Schneck & Hübner Patentanwälte Rechtsanwälte PartGmbB
(86) Internationale Anmeldenummer: PCT/EP2019/069679
(87) Internationale Veröffentlichungsnummer: WO 2020/020823

(56) Entgegenhaltungen:
- WO-A2-2004/038874
- US-A1- 2002 191 650
- US-A1- 2006 193 553

## Beschreibung

Die vorliegende Patentanmeldung nimmt die Priorität der deutschen Patentanmeldung DE 10 2018 212 224.5 in Anspruch.

US 2006/193553 A1 offenbart eine optische Vorrichtung, die einen Laser und einen planaren Lichtwellenleiter mit Beugungselementen und Mitteln zur Führung eines optischen Signals umfasst.

Die Erfindung betrifft eine Strahlungsquelle für ein Projektionsbelichtungssystem oder Metrologiesystem gemäß Anspruch 1. Weiterhin betrifft die Erfindung eine Vorrichtung zur Rückkopplung von emittierter Beleuchtungsstrahlung in eine Laser-Quelle gemäß Anspruch 9. Außerdem betrifft die Erfindung ein Verfahren zur Betrieb eines Freie Elektonen Lasers gemäß Anspruch 10. Des weiteren betrifft die Erfindung ein Verfahren zur Herstellung eines mikro- oder nanostrukturierten Bauelements gemäß Anspruch 15. Bauelement Ebenfalls betrifft die Erfindung ein Bauelement hergestellt nach einem Verfahren gemäß Anspruch 16.

Als Strahlungsquellen für EUV-Projektionsbelichtungsanlagen kommen beispielsweise Freie Elektronenlaser (FEL) in Betracht. Derartige FEL haben üblicherweise sehr große Abmessungen. Außerdem kann es bei der Entsorgung des verbrauchten Elektronenstrahls zur Freisetzung von Radioaktivität kommen.

Es ist daher eine Aufgabe der Erfindung, eine Strahlungsquelle für eine Projektionsbelichtungsanlage zu verbessern.

Diese Aufgabe wird durch eine Vorrichtung zur Rückkopplung von emittierter Strahlung in eine Laserquelle sowie eine Strahlungsquelle mit einer derartigen Vorrichtung gelöst.

Der Kern der Erfindung besteht darin, einen Teil der emittierten Strahlung aus einem Strahlengang auszukoppeln und zumindest einen Anteil der ausgekoppelten Strahlung wieder in die Laser-Quelle einzukoppeln.

Die emittierte Strahlung kann insbesondere als Beleuchtungsstrahlung, insbesondere für eine Projektionsbelichtungsanlage, dienen. Im Folgenden wird anstelle des Begriffs Strahlung beziehungsweise elektromagnetische Strahlung auch der Begriff Beleuchtungsstrahlung verwendet.

Dies ist nicht einschränkend zu verstehen. Die Vorteile der vorliegenden Erfindung ergeben sich auch bei anderen Anwendungen.

Mit Hilfe der optischen Komponenten zum Auskoppeln von elektromagnetischer Strahlung aus dem Strahlengang und zur Einkopplung zumindest eines Anteils der ausgekoppelten elektromagnetischen Strahlung, insbesondere zur Einkopplung eines sogenannten Seed-Pulses in die Laser-Quelle, insbesondere in einen Speicherring derselben, kann die Größe der Strahlungsquelle erheblich reduziert werden.

Bei der elektromagnetischen Strahlung handelt es sich insbesondere um Strahlung mit einer Wellenlänge von höchstens 30 nm, insbesondere um EUV-Strahlung, insbesondere um Strahlung in einem Wellenlängenbereich von 5 nm bis 30 nm, beispielsweise von 13,5 nm oder 6,8 nm. Es handelt sich insbesondere um Beleuchtungsstrahlung zum Betrieb einer Projektionsbelichtungsanlage für die Mikrolithographie.

Bei der Laser-Quelle handelt es sich um einen Freie Elektronen Laser.

Zur Auskopplung von elektromagnetischer Strahlung aus dem Strahlengang dient insbesondere ein diffraktives optisches Element. Dieses kann auf der Komponente zur Auskopplung von elektromagnetischer Strahlung angeordnet sein.

Mit Hilfe der Vorrichtung kann ein FEL mit einem Self Seed-Mechanismus versehen werden. Vorzugsweise ist die Vorrichtung zur Rückkopplung der emittierten elektromagnetischen Strahlung in die Laser-Quelle derart ausgebildet, dass ein Mode-Matching der eingekoppelten elektromagnetischen Strahlung zu der in der Laser-Quelle generierten elektromagnetischen Strahlung erfolgt. Es erfolgt insbesondere eine Moden-angepasste Wiedereinkopplung von Seed-Pulsen in die Laser-Quelle.

Gemäß einem Aspekt der Erfindung weisen die mindestens eine optische Komponente zur Auskopplung von elektromagnetischer Strahlung aus dem Strahlengang und/oder die mindestens eine optische Komponente zur Einkopplung von elektromagnetischer Strahlung in die Laser-Quelle jeweils einen Spiegel für streifenden Einfall (GI-Spiegel; Grazing Incidence Spiegel) auf.

Mittels eines Grazing Incidence Spiegels kann eine Aufweitung des Beleuchtungsstrahls erreicht werden. Dies kann zu einer Verringerung der Thermallast auf den optischen Komponenten genutzt werden.

Der Einfallswinkel (Grazing Angle) liegt vorzugsweise bei weniger als 15°, insbesondere weniger als 10°. Er kann beispielsweise 0,1rad = 5,7° betragen.

Der Spiegel der Komponente zur Auskopplung von elektromagnetischer Strahlung aus dem Strahlengang ist vorzugsweise superpoliert. Er weist im Nutzbereich einen integralen Passefehler von höchstens 10nm rms , bevorzugt 2,5 nm rms, (root mean square) für Ortswellenlängen größer 1mm bis zur freien Apertur des Spiegels und eine integrale rms-Rauheit von höchstens 1nm, bevorzugt 0,5nm rms, für Ortsfrequenzen zwischen 10nm und 1mm auf. Gemäß einem weiteren Aspekt der Erfindung ist der Spiegel der optischen Komponente zur Auskopplung von elektromagnetischer Strahlung mindestens 1 m, insbesondere mindestens 2 m, insbesondere mindestens 5 m, insbesondere mindestens 8 m vom Ausgang der Laser-Quelle entfernt angeordnet. Der Abstand beträgt vorzugsweise höchstens 30 m, insbesondere höchstens 20 m, insbesondere höchstens 12 m.

Die der optischen Komponente zur Auskopplung von elektromagnetischer Strahlung nachfolgende optische Komponente der Vorrichtung zur Rückkopplung von elektromagnetischer Strahlung ist in Vorwärtsrichtung mindestens 1 m, insbesondere mindestens 2 m, insbesondere mindestens 3 m, insbesondere mindestens 5 m, insbesondere mindestens 8 m, jedoch vorzugsweise höchstens 30 m, insbesondere höchstens 20 m, insbesondere höchstens 12 m vom GI-Spiegel entfernt. Hierdurch kann einerseits die Aufweitung des ausgekoppelten Beleuchtungsstrahls, andererseits der transversale Abstand des rücklaufenden Strahls zum hinlaufenden Strahl beeinflusst werden.

Gemäß einem weiteren Aspekt der Erfindung ist der GI-Spiegel der optischen Komponente zur Auskopplung von elektromagnetischer Strahlung als konvexer Spiegel, insbesondere als in erster Näherung außeraxialer Paraboloid-Spiegel oder als Ellipsoid-Spiegel, insbesondere mit einer Strahltaille (Beam Waist) in einem Fokuspunkt oder als Hyperboloid-Spiegel oder als Freiformflächen-Spiegel ausgebildet.

Gemäß einem weiteren Aspekt der Erfindung ist der Spiegel der Komponente zur Einkopplung der elektromagnetischen Strahlung in die Laser-Quelle abgesehen von der diffraktiven Struktur im Wesentlichen identisch zum Spiegel der optischen Komponente zur Auskopplung von elektromagnetischer Strahlung ausgebildet.

Gemäß einem weiteren Aspekt der Erfindung ist das diffraktive optische Element ansteuerbar ausgebildet. Es handelt sich insbesondere um ein steuerbares Gitterelement. Es kann sich beispielsweise um ein akustooptisches Element handeln. Für Details sei auf die DE 10 2016 217 426 A1 verwiesen.

Das diffraktive optische Element weist insbesondere eine variable, insbesondere eine steuerbare Gitterkonstante auf. Dies ermöglicht eine variable, insbesondere eine steuerbare Leistungsrücckopplung in den FEL.

Alternativ hierzu kann das diffraktive optische Element auch als statisches Gitter ausgebildet sein. Dies ermöglicht eine besonders einfache Umsetzung der Erfindung.

Das diffraktive optische Element kann insbesondere mindestens 30 Linien pro Millimeter, insbesondere mindestens 38 Linien pro Millimeter aufweisen. Die Liniendichte kann geringer sein als 100 Linien pro Millimeter. Hierdurch ist es möglich, zwei benachbarte Ordnungen an dem dem diffraktiven optischen Element nachfolgenden optischen Element (M2) um mindestens den Strahldurchmesser zu separieren.

Gemäß einem weiteren Aspekt der Erfindung kann das diffraktive optische Element geblazt (Blazed Grating) ausgebildet sein. Hierdurch ist es möglich, die reflektierte Leistung in wenige, insbesondere in zwei Ordnungen, zu konzentrieren.

Gemäß einem weiteren Aspekt der Erfindung ist vorgesehen, die nullte Ordnung oder eine höhere Ordnung, als Seed-Puls zur Wiedereinkopplung in die Laser-Quelle zu verwenden. Gemäß einem weiteren Aspekt der Erfindung weist das diffraktive optische Element Linien senkrecht zur Strahlrichtung auf.

Alternativ hierzu kann das diffraktive optische Element Linien in Strahlrichtung aufweisen. Es kann insbesondere als konisches Gitter ausgebildet sein. Details zur Auslegung können der WO2004/021086 A1 und der DE 10 2012 201 497 A1 entnommen werden. Ein konischen Gitters beugt die von Null verschiedenen Beugungsordnungen aus der Einfallsebene heraus, d.h. mit einer Richtungskomponente in Richtung des Gittervektors. Ein (konventionelles) Gitter mit Linien senkrecht zur Lichtrichtung beugt innerhalb der Einfallsebene. Je nach Bauraumbedingungen kann durch entsprechende Wahl eine optimale Auslegung erreicht werden.

Gemäß einem weiteren Aspekt der Erfindung ist mindestens einer der Spiegel für streifenden Einfall hergestellt aus Siliziumkarbid, Silizium, Kupfer, Ruthenium, Aluminium oder Diamant oder weist Bestandteile dieser Stoffe
oder deren Verbindungen oder Legierungen auf. Der Spiegel für streifenden Einfall kann insbesondere aus den vorgenannten Stoffen oder deren Verbindungen oder einer Kombination derselben bestehen.

Gemäß einem weiteren Aspekt der Erfindung weist die mindestens eine optische Komponente mit dem diffraktiven optischen Element eine Kühleinrichtung auf. Die Komponente kann insbesondere innengekühlt sein. Als Kühlmedium kann eine Auswahl aus Wasser, Öl, Kohlendioxid oder Stickstoff dienen. Beispiele für die Integration einer Kühleinrichtung können z.B. der WO2007/051638A1, der US2010/0182710A1 oder der US9007559B2 oder den DE 10 2012 201 221 A1, DE 10 2015 100 918 A1, DE 10 2009 039400 A1, DE 10 2016 221 878 A1 entnommen werden.

Gemäß einem weiteren Aspekt der Erfindung umfasst die Vorrichtung zur Rückkopplung von elektromagnetischer Strahlung in die Laser-Quelle zwei Spiegel für streifenden Einfall und zwei Spiegel für senkrechten Einfall (NI-Spiegel, Normal Incidence Spiegel).

Die Vorrichtung umfasst insbesondere jeweils genau zwei GI- und zwei NI-Spiegel.

Es hat sich gezeigt, dass hierdurch die Thermallast auf den einzelnen Spiegeln unterhalb eines vorgegebenen Grenzwertes, insbesondere unterhalb von 1000 W/cm², insbesondere unterhalb von 500 W/cm², insbesondere unterhalb von 300 W/cm², insbesondere unterhalb von 200 W/cm² gehalten werden konnte. Gemäß einem weiteren Aspekt der Erfindung sind die Spiegel der Vorrichtung symmetrisch, insbesondere spiegelsymmetrisch, zu einer Mittenebene angeordnet. Vorzugsweise weist die Vorrichtung insgesamt einen symmetrischen Aufbau auf. Dies erleichtert eine Moden-angepasste Wiedereinkopplung der elektromagnetischen Strahlung, insbesondere der Seed-Pulse.

Die Vorteile einer Strahlungsquelle mit einer Rückkopplungsvorrichtung gemäß der vorhergehenden Beschreibung ergeben sich aus den bereits beschriebenen.

Bei der Strahlungsquelle handelt es sich insbesondere um eine EUV-Strahlungsquelle, das heißt um eine Strahlungsquelle zur Erzeugung von elektromagnetischer Strahlung im EUV-Wellenlängenbereich.

Eine weitere Aufgabe der Erfindung besteht darin, ein Verfahren zum Betrieb eines Freie Elektronen Lasers zu verbessern.

Diese Aufgabe wird durch ein Verfahren gelöst, bei welchem ein Teil der vom FEL erzeugten elektromagnetischen Strahlung aus dem Strahlengang ausgekoppelt und zumindest teilweise wieder in dem FEL eingekoppelt wird.

Es ist insbesondere vorgesehen, Seed-Pulse in den FEL wieder einzukoppeln.

Die Wiedereinkopplung erfolgt insbesondere Moden-angepasst.

Die Erfindung bezieht sich auf einen Kompaktspeicherring basierten FEL der weit unterhalb der Sättigung (ca. <1% der Sättigungsleistung) betrieben wird, sodass die Degradation der Elektronenstrahlqualität durch den FEL-Prozess so gering gehalten werden, dass ein Speichern des Elektronenstrahls möglich wird.

Details zur Auslegung dieses FELs können den Publikationen der Fa. Lyncean Technologies Inc. Michael Feser, https://www.euvlitho.com/2017/P17.pdf und Michael Feser et al, Proc SPIE Vol 10450 1045011-2 (2017) entnommen werden.

Die EUV-Gesamtleistung, welche im Kilowattbereich liegen kann, kommt insbesondere durch eine hohe Repetitionsrate zustande. Die Repetitionsrate beträgt insbesondere mindestens 5 MHz, insbesondere mindestens 10 MHz, insbesondere mindestens 20 MHz, insbesondere mindestens 30 MHz, insbesondere mindestens 50 MHz, insbesondere mindestens 100 MHz, insbesondere mindestens 200 MHz, insbesondere mindestens 300 MHz. Sie beträgt üblicherweise weniger als 1 GHz.

Im Speicherring können vorzugsweise mehrere Pulse, insbesondere mindestens 5 Pulse, insbesondere mindestens 10 Pulse, insbesondere mindestens 20 Pulse, insbesondere mindestens 30 Pulse, insbesondere mindestens 50 Pulse gespeichert werden.

Da die Elektronen über einen langen Zeitraum gespeichert werden können, sinkt die Anzahl der zu entsorgenden Elektronen dramatisch. Damit vereinfacht sich auch das Strahlenschutzproblem

Die Leistung des wiedereingekoppelten Anteils der ausgekoppelten elektromagnetischen Strahlung beträgt insbesondere mindestens 10 W, insbesondere mindestens 20 W, insbesondere mindestens 30 W, insbesondere mindestens 50 W, insbesondere mindestens 100 W. Sie beträgt vorzugsweise weniger als 1 kW, insbesondere weniger als 500 W, insbesondere weniger als 300 W, insbesondere weniger als 200 W.

Gemäß einem weiteren Aspekt der Erfindung kann der genaue Wert der wiedereingekoppelten Leistung durch Steuerung des diffraktiven optischen Elements gesteuert werden. Hierdurch wird die Flexibilität der Rückkopplung verbessert.

Gemäß einem weiteren Aspekt der Erfindung ist vorgesehen, die zur Beleuchtung des Objektfeldes genutzte elektromagnetische Strahlung, insbesondere deren Intensität, durch Ansteuern des diffraktiven optischen Elements zu steuern, insbesondere zu regeln. Es ist insbesondere möglich, die zur Abbildung des Retikels auf einem Wafer im Bildfeld der Projektionsoptik genutzte elektromagnetische Strahlung, insbesondere deren Intensität, durch Ansteuern des diffraktiven optischen Elements zu steuern, insbesondere zu regeln.

Mittels geeigneter Feedback- und/oder Feedforward-Informationen kann insbesondere eine Dosiskontrolle auf Retikel- und/oder Waferebene realisiert werden.

Weitere Aufgaben der Erfindung bestehen darin, ein Beleuchtungssystem für ein Projektionsbelichtungssystem oder ein Metrologiesystem sowie ein Projektionsbelichtungssystem und ein Metrologiesystem mit einem entsprechenden Beleuchtungssystem zu verbessern.

Diese Aufgaben werden durch ein Beleuchtungssystem mit einer Strahlungsquelle gemäß der vorhergehenden Beschreibung gelöst. Die Vorteile ergeben sich aus den bereits beschriebenen.

Mit Hilfe des Beleuchtungssystems ist es insbesondere möglich, einen Teil der vom FEL erzeugten elektromagnetischen Strahlung zum Seeden in diesen rückzukoppeln. Die nicht zum Seed genutzten Beugungsordnungen werden vorzugsweise unobskuriert zu einem oder mehreren Scannern des Projektionsbelichtungssystems, insbesondere zu einer oder mehreren Projektionsoptiken, geführt. Für Details eines entsprechenden Projektionsbelichtungssystems sei wiederum auf die DE 10 2016 217 426 A1 verwiesen.

Weitere Aufgaben der Erfindung bestehen darin, ein Verfahren zur Herstellung eines mikro- oder nanostrukturierten Bauelements sowie ein derartiges Bauelement zu verbessern.

Diese Aufgaben werden durch Bereitstellen eines Projektionsbelichtungssystems gemäß der vorhergehenden Beschreibung gelöst.

Weitere Vorteile und Details der Erfindung ergeben sich aus der Beschreibung von Ausführungsbeispielen anhand der Figuren. Es zeigen:
- Fig. 1: schematisch den prinzipiellen Aufbau eines Projektionsbelichtungssystems mit einer Mehrzahl von n Scannern,
- Fig. 2: schematisch eine alternative Darstellung des Strahlengangs im Projektionsbelichtungssystem gemäß Fig. 1 und
- Fig. 3: schematisch eine Detailansicht des Strahlungsquellenmoduls des Projektionsbelichtungssystems gemäß Fig. 1 mit einer Vorrichtung zur Rückkopplung von Beleuchtungsstrahlung.

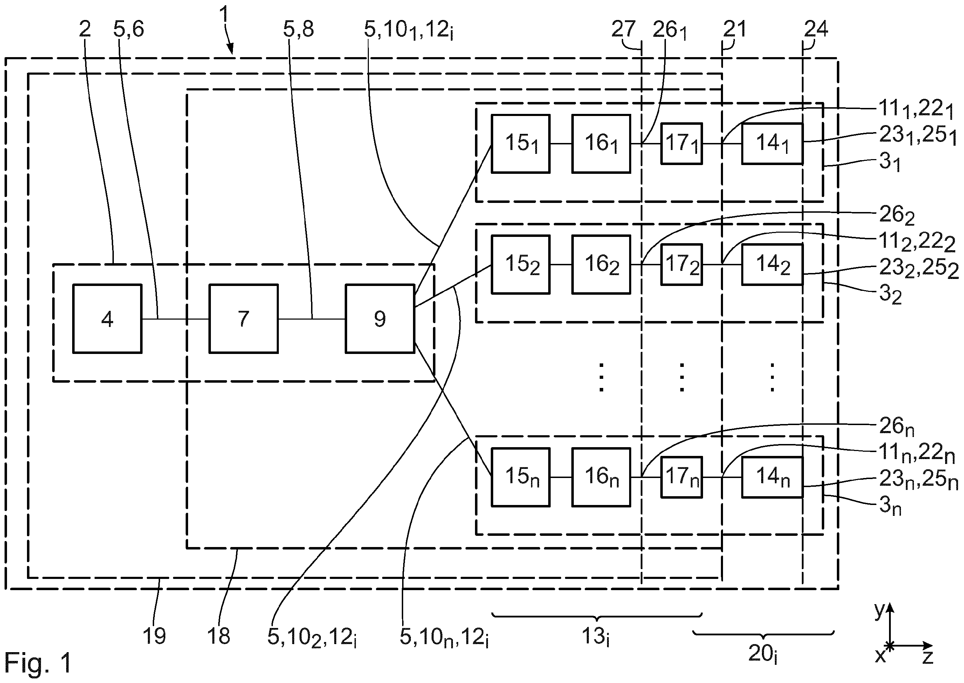

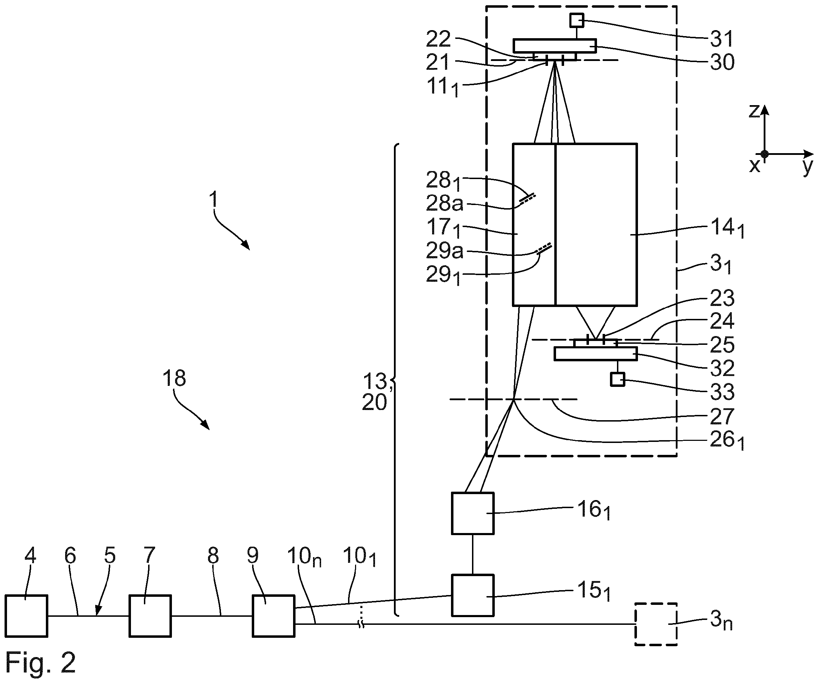

Im Folgenden werden unter Bezugnahme auf die Fig. 1 und 2 zunächst die wesentlichen Bestandteile eines Projektionsbelichtungssystems 1 beschrieben. Für weitere Details sei stellvertretend auf die Beschreibung der DE 10 2016 217 426 A1 verwiesen.

Die nachfolgend vorgenommene Unterteilung des Projektionsbelichtungssystems 1 in Teilsysteme dient primär der begrifflichen Abgrenzung derselben. Die Teilsysteme können separate konstruktive Teilsysteme bilden. Die Aufteilung in Teilsysteme muss sich jedoch nicht notwendigerweise in einer konstruktiven Abgrenzung widerspiegeln.

Das Projektionsbelichtungssystem 1 umfasst ein Strahlungsquellenmodul 2 und einen oder eine Mehrzahl von Scannern 3ᵢ.

Das Strahlungsquellenmodul 2 umfasst eine Strahlungsquelle 4 zur Erzeugung von Beleuchtungsstrahlung 5.

Bei der Strahlungsquelle 4 handelt es sich um einen Freie Elektronen-Laser (FEL).

Die Strahlungsquelle 4 hat beispielsweise eine mittlere Leistung im Bereich von 1 kW bis 25 kW. Sie weist eine Pulsfrequenz im Bereich von 10 MHz bis 10 GHz auf. Jeder einzelne Strahlungsimpuls kann beispielsweise eine Energie von 83 µJ betragen. Bei einer Strahlungsimpulslänge von 100 fs entspricht dies einer Strahlungsimpulsleistung von 833 MW.

Die Strahlungsquelle 4 kann auch eine Repetitionsrate im Kilohertzbereich, beispielsweise von 100 kHz, oder im niederen Megahertzbereich, beispielsweise bei 3 MHz, im mittleren Megahertzbereich, beispielsweise bei 30 MHz, im oberem Megahertzbereich, beispielsweise bei 300 MHz oder auch im Gigahertzbereich, beispielsweise bei 1,3 GHz, besitzen.

Bei der Strahlungsquelle 4 handelt es sich insbesondere um eine EUV-Strahlungsquelle. Die Strahlungsquelle 4 emittiert insbesondere Strahlung mit einer Wellenlänge von höchstens 30 nm, insbesondere EUV-Strahlung im Wellenlängenbereich beispielsweise zwischen 2 nm und 30 nm, insbesondere zwischen 2 nm und 15 nm.

Die Strahlungsquelle 4 emittiert die Beleuchtungsstrahlung 5 in Form eines Rohstrahls 6. Der Rohstrahl 6 hat eine sehr kleine Divergenz. Die Divergenz des Rohstrahls 6 kann kleiner als 10 mrad sein, insbesondere kleiner als 1 mrad, insbesondere kleiner als 100 µrad, insbesondere kleiner als 10 µrad. Zur einfacheren Beschreibung von Lageverhältnissen werden im Folgenden Koordinaten eines kartesischen xyz-Koordinatensystems verwendet. Die x-Koordinate spannt mit der y-Koordinate regelmäßig einen Bündelquerschnitt der Beleuchtungsstrahlung 5 auf. Die z-Richtung verläuft regelmäßig in Strahlungsrichtung der Beleuchtungsstrahlung 5. Im Bereich der Objektebene 21 beziehungsweise der Bildebene 24 verläuft die y-Richtung parallel zu einer Scanrichtung. Die x-Richtung verläuft senkrecht zur Scanrichtung. Der Rohstrahl 6 wird von der Strahlungsquelle 4 in eine bestimmte Richtung emittiert. Diese wird im Folgenden auch als Pointing P bezeichnet.

Der Rohstrahl 6 kann einen Lichtleitwert aufweisen, welcher kleiner ist als 0,1 mm², insbesondere kleiner als 0,01 mm². Beim Lichtleitwert handelt es sich um das kleinste Volumen eines Phasenraums, welches 90 % der Energie der von der Strahlungsquelle 2 emittierten Beleuchtungsstrahlung 5 enthält. Hierzu entsprechende Definitionen des Lichtleitwerts finden sich beispielsweise in der EP 1 072 957 A2 und der US 6 198 793 B1.

Das Strahlungsquellenmodul 2 umfasst weiterhin eine der Strahlungsquelle 4 nachgeordnete Strahlformungsoptik 7. Die Strahlformungsoptik 7 dient zur Erzeugung eines Sammel-Ausgabestrahls 8 aus dem Rohstrahl 6. Der Sammel-Ausgabestrahl 8 hat eine sehr kleine Divergenz. Die Divergenz des Sammel-Ausgabestrahls 8 kann kleiner als 10 mrad sein, insbesondere kleiner als 1 mrad, insbesondere kleiner als 100 µrad, insbesondere kleiner als 10 µrad.

Mittels der Strahlformungsoptik 7 kann insbesondere der Durchmesser des Rohstrahls 6 beziehungsweise des Sammel-Ausgabestrahls 8 beeinflusst werden. Mittels der Strahlformungsoptik 7 kann insbesondere eine Aufweitung des Rohstrahls 6 erreicht werden. Der Rohstrahl 6 kann mittels der Strahlformungsoptik 7 insbesondere um einen Faktor von mindestens 1,5, insbesondere mindestens 2, insbesondere mindestens 3, insbesondere mindestens 5, insbesondere mindestens 10 aufgeweitet werden. Der Aufweitungsfaktor ist insbesondere kleiner als 1000. Es ist auch möglich, den Rohstrahl 6 in unterschiedlichen Richtungen unterschiedlich stark aufzuweiten. Er kann insbesondere in einer x-Richtung stärker aufgeweitet werden als in einer y-Richtung. Hierbei entspricht die y-Richtung im Bereich des Objektfeldes 11ᵢ der Scanrichtung. Die Divergenz des Sammel-Ausgabestrahls 8 kann kleiner sein als die Divergenz, insbesondere kleiner als die halbe Divergenz, des Rohstrahls 6.

Für weitere Details der Strahlformungsoptik 7 sei auf die DE 10 2013 223 935 A1 verwiesen. Die Strahlformungsoptik 7 kann insbesondere eine oder zwei Strahlformungsspiegelgruppen mit jeweils zwei Spiegeln aufweisen. Die Strahlformungsspiegelgruppen dienen insbesondere zur Strahlformung des Sammel-Ausgabestrahls 8 in zueinander senkrechten Ebenen, welche parallel zur Ausbreitungsrichtung des Sammel-Ausgabestrahls 8 verlaufen.

Die Strahlformungsoptik 7 kann auch weitere Strahlformungsspiegel umfassen.

Die Strahlformungsoptik 7 kann insbesondere Zylinderspiegel, insbesondere mindestens einen konvexen und mindestens einen konkaven Zylinderspiegel, umfassen. Sie kann auch Spiegel mit einem Freiformprofil umfassen. Derartige Spiegel weisen jeweils ein Höhenprofil auf, welches nicht als Kegelschnitt darstellbar ist.

Mittels der Strahlformungsoptik 7 kann außerdem das Intensitätsprofil des Rohstrahls 6 beeinflusst werden.

Außerdem umfasst das Strahlungsquellenmodul 2 eine nachfolgend noch näher beschriebene Auskoppeloptik 9. Die Auskoppeloptik 9 dient zur Erzeugung von mehreren, nämlich von n, Einzelausgabestrahlen 10ᵢ (i = 1 bis n) aus dem Sammel-Ausgabestrahl 8. Die Einzelausgabestrahlen 10ᵢ bilden jeweils Strahlenbündel zur Beleuchtung eines Objektfeldes 11ᵢ. Die Einzelausgabestrahlen 10ᵢ sind jeweils einem der Scanner 3ᵢ zugeordnet. Die Strahlenbündel der Einzelausgabestrahlen 10ᵢ können jeweils eine Mehrzahl von separaten Teilstrahlen 12ᵢ umfassen.

Wie nachfolgend noch näher beschrieben wird, kann die Funktionalität der Strahlformungsoptik 7 in die Auskoppeloptik 9 integriert sein. In diesem Fall kann auf eine separate Strahlformungsoptik 7 verzichtet werden.

Bei der Alternative gemäß Fig. 2 ist die Auskoppeloptik 9 in Ausbreitungsrichtung der Beleuchtungsstrahlung hinter der Strahlformungsoptik 7 angeordnet. Vorzugsweise ist die Auskoppeloptik 9 direkt hinter der Strahlungsquelle 4, insbesondere vor der Beeinflussung des Rohstrahls 6 mittels der Strahlformungsoptik 7 angeordnet. In diesem Fall können separate Strahlformungsoptiken für die einzelnen Einzel-Ausgabestrahlen 10; vorgesehen sein. Durch eine derartige Anordnung der Auskoppeloptik 9 können Strahlungsverluste aufgrund von Dämpfung an der Auskoppeloptik 9 verringert werden.

Das Strahlungsquellenmodul 2 ist insbesondere in einem evakuierbaren Gehäuse angeordnet.

Die Scanner 3ᵢ umfassen jeweils eine Strahlführungsoptik 13ᵢ und eine Projektionsoptik 14ᵢ.

Die Strahlführungsoptik 13ᵢ dient der Führung der Beleuchtungsstrahlung 5, insbesondere der jeweiligen Einzel-Ausgabestrahlen 10; zu den Objektfeldern 11ᵢ der einzelnen Scanner 3ᵢ.

Die Projektionsoptik 14ᵢ dient jeweils der Abbildung eines in einem der Objektfelder 11ᵢ angeordneten Retikels 22ᵢ in ein Bildfeld 23ᵢ, insbesondere auf einen im Bildfeld 23ᵢ angeordneten Wafer 25ᵢ.

Die Strahlungsführungsoptik 13ᵢ umfasst in der Reihenfolge des Strahlengangs der Beleuchtungsstrahlung 5 jeweils eine Umlenkoptik 15ᵢ, eine Einkoppeloptik 16ᵢ, insbesondere in Form einer Fokussier-Baugruppe, und eine Beleuchtungsoptik 17ᵢ. Die Einkoppeloptik 16ᵢ kann insbesondere auch als Wolter-Typ-III-Kollektor ausgebildet sein.

Die Umlenkoptik 15ᵢ kann auch in die Auskoppeloptik 9 integriert sein. Die Auskoppeloptik 9 kann insbesondere derart ausgebildet sein, dass sie die Einzelausgabestrahlen 10; bereits in eine gewünschte Richtung umlenkt. Gemäß einer Variante kann auch auf die Umlenkoptiken 15ᵢ insgesamt verzichtet werden. Allgemein können die Auskoppeloptik 9 und die Umlenkoptiken 15ᵢ eine Auskoppel-Umlenk-Einrichtung bilden.

Für unterschiedliche Varianten der Umlenkoptiken 15ᵢ sei beispielsweise auf die DE 10 2013 223 935 A1 verwiesen.

Die Einkoppeloptik 16ᵢ dient insbesondere dem Einkoppeln der Beleuchtungsstrahlung 5, insbesondere eines der von der Auskoppeloptik 9 erzeugten Einzel-Ausgabestrahlen 10ᵢ in jeweils eine der Beleuchtungsoptiken 17ᵢ.

Die Strahlführungsoptik 13ᵢ bildet zusammen mit der Strahlformungsoptik 7 und der Auskoppeloptik 9 Bestandteile einer Beleuchtungseinrichtung 18.

Die Beleuchtungseinrichtung 18 ist ebenso wie die Strahlungsquelle 4 Bestandteil eines Beleuchtungssystems 19.

Jeder der Beleuchtungsoptiken 17ᵢ ist jeweils eine der Projektionsoptiken 14ᵢ zugeordnet. Zusammen werden die einander zugeordnete Beleuchtungsoptik 17ᵢ und die Projektionsoptik 14ᵢ auch als optisches System 20ᵢ bezeichnet.

Die Beleuchtungsoptik 17ᵢ dient jeweils zur Überführung von Beleuchtungsstrahlung 5 zu einem im Objektfeld 11ᵢ in einer Objektebene 21 angeordneten Retikel 22ᵢ. Die Projektionsoptik 14ᵢ dient zur Abbildung des Retikels 22ᵢ, insbesondere zur Abbildung von Strukturen auf dem Retikel 22ᵢ, auf einen in einem Bildfeld 23ᵢ in einer Bildebene 24 angeordneten Wafer 25ᵢ.

Die Beleuchtungsoptik 17ᵢ umfasst jeweils einen ersten Facettenspiegel 28ᵢ und einen zweiten Facettenspiegel 29ᵢ, deren Funktion jeweils derjenigen entspricht, die aus dem Stand der Technik bekannt sind. Beim ersten Facettenspiegel 28ᵢ kann es sich insbesondere um einen Feldfacettenspiegel handeln. Beim zweiten Facettenspiegel 29ᵢ kann es sich insbesondere um einen Pupillenfacettenspiegel handeln. Der zweite Facettenspiegel 29ᵢ kann jedoch auch beabstandet zu einer Pupillenebene der Beleuchtungsoptik 17 angeordnet sein. Dieser allgemeine Fall wird auch als spekularer Reflektor bezeichnet.

Die Facettenspiegel 28ᵢ, 29ᵢ umfassen jeweils eine Vielzahl von Facetten 28a, 29a. Beim Betrieb des Projektionsbelichtungssystems 1 ist jeder der ersten Facetten 28a jeweils eine der zweiten Facetten 29a zugeordnet. Die einander zugeordneten Facetten 28a, 29a bilden jeweils einen Beleuchtungskanal der Beleuchtungsstrahlung 5 zur Beleuchtung des Objektfeldes 11 unter einem bestimmten Beleuchtungswinkel.

Die Facetten 28a des ersten Facettenspiegel 28ᵢ können verlagerbar, insbesondere verkippbar, insbesondere mit jeweils zwei Kippfreiheitsgraden, ausgebildet sein. Die Facetten 28a des ersten Facettenspiegels 28; können als virtuelle Facetten ausgebildet sein. Hierunter sein verstanden, dass sie durch eine variable Gruppierung aus einer Mehrzahl von Einzelspiegeln, insbesondere eine Mehrzahl von Mikrospiegeln, gebildet werden. Für Details sei auf die WO 2009/100856 A1 verwiesen, die hiermit als Bestandteil der vorliegenden Anmeldung in diese integriert ist.

Die Facetten 29a des zweiten Facettenspiegels 29; können entsprechend als virtuelle Facetten 29a ausgebildet sein. Sie können auch entsprechend verlagerbar, insbesondere verkippbar, ausgebildet sein.

Das Retikel 22 mit für die Beleuchtungsstrahlung 5 reflektierenden Strukturen wird von einem Retikelhalter 30 getragen. Der Retikelhalter 30 ist über eine Verlagerungseinrichtung 31 angesteuert verlagerbar.

Der Wafer 25 wird von einem Waferhalter 32 getragen. Der Waferhalter 32 ist mittels einer Verlagerungseinrichtung 33 gesteuert verlagerbar.

Die Verlagerungseinrichtung 31 des Retikelhalters 30 und die Verlagerungseinrichtung 33 des Waferhalters 32 können in Signalverbindung miteinander stehen. Sie sind insbesondere synchronisiert. Das Retikel 22 und der Wafer 25 sind insbesondere synchronisiert zueinander verlagerbar.

Bei der Projektionsbelichtung zur Herstellung eines mikro- oder nanostrukturierten Bauelements werden sowohl das Retikel 22 als auch der Wafer 25 durch entsprechende Ansteuerung der Verlagerungseinrichtungen 31 und 33 synchronisiert verlagert, insbesondere synchronisiert gescannt. Der Wafer 25 wird während der Projektionsbelichtung mit einer Scangeschwindigkeit von beispielsweise 600 mm/s gescannt.

Das Projektionsbelichtungssystem 1 umfasst insbesondere mindestens zwei, insbesondere mindestens drei, insbesondere mindestens vier, insbesondere mindestens fünf, insbesondere mindestens sechs, insbesondere mindestens sieben, insbesondere mindestens acht, insbesondere mindestens neun, insbesondere mindestens zehn Scanner 3ᵢ. Das Projektionsbelichtungssystem 1 kann bis zu zwanzig Scanner 3; umfassen.

Die Scanner 3ᵢ werden von dem gemeinsamen Strahlungsquellenmodul 2, insbesondere der gemeinsamen Strahlungsquelle 4, mit Beleuchtungsstrahlung 5 versorgt.

Das Projektionsbelichtungssystem 1 dient zur Herstellung von mikro- beziehungsweise nanostrukturierten Bauelementen, insbesondere elektronischen Halbleiter-Bauelementen.

Die Einkoppeloptik 16ᵢ ist im Strahlengang zwischen dem Strahlungsquellenmodul 2, insbesondere der Auskoppeloptik 9, und jeweils einer der Beleuchtungsoptiken 17ᵢ angeordnet. Sie ist insbesondere als Fokussier-Baugruppe ausgebildet. Sie dient der Überführung jeweils eines der Einzel-Ausgabestrahlen 10; in einen Zwischenfokus 26ᵢ in einer Zwischenfokusebene 27. Der Zwischenfokus 26ᵢ kann im Bereich einer Durchtrittsöffnung eines Gehäuses des optischen Systems 20; oder des Scanners 3; angeordnet sein. Das Gehäuse ist insbesondere evakuierbar.

Die Beleuchtungsoptik 17ᵢ umfasst jeweils einen ersten Facettenspiegel und einen zweiten Facettenspiegel, deren Funktion jeweils derjenigen entspricht, die aus dem Stand der Technik bekannt sind. Beim ersten Facettenspiegel kann es sich insbesondere um einen Feldfacettenspiegel handeln. Beim zweiten Facettenspiegel kann es sich insbesondere um einen Pupillenfacettenspiegel handeln. Der zweite Facettenspiegel kann jedoch auch beabstandet zu einer Pupillenebene der Beleuchtungsoptik 17; angeordnet sein. Dieser allgemeine Fall wird auch als spekularer Reflektor bezeichnet.

Die Facettenspiegel umfassen jeweils eine Vielzahl von ersten beziehungsweise zweiten Facetten. Beim Betrieb des Projektionsbelichtungssystems 1 ist jeder der ersten Facetten jeweils eine der zweiten Facetten zugeordnet. Die einander zugeordneten Facetten bilden jeweils einen Beleuchtungskanal der Beleuchtungsstrahlung 5 zur Beleuchtung des Objektfeldes 11ᵢ unter einem bestimmten Beleuchtungswinkel.

Die kanalweise Zuordnung der zweiten Facetten zu den ersten Facetten erfolgt in Abhängigkeit einer gewünschten Beleuchtung, insbesondere eines vorgegebenen Beleuchtungssettings. Die Facetten des ersten Facettenspiegels können verlagerbar, insbesondere verkippbar, insbesondere mit jeweils zwei Kippfreiheitsgraden, ausgebildet sein. Die Facetten des ersten Facettenspiegels sind insbesondere zwischen unterschiedlichen Stellungen schaltbar. Sie sind in unterschiedlichen Schaltstellungen unterschiedlichen der zweiten Facetten zugeordnet. Es kann jeweils auch mindestens eine Schaltstellung der ersten Facetten vorgesehen sein, in welcher die auf sie auftreffende Beleuchtungsstrahlung 5 nicht zur Beleuchtung des Objektfeldes 11ᵢ beiträgt. Die Facetten des ersten Facettenspiegels können als virtuelle Facetten ausgebildet sein. Hierunter sei verstanden, dass sie durch eine variable Gruppierung einer Mehrzahl von Einzelspiegeln, insbesondere einer Mehrzahl von Mikrospiegeln, gebildet werden. Für Details sei auf die WO 2009/100856 A1 verwiesen, die hiermit als Bestandteil der vorliegenden Anmeldung in diese integriert ist.

Die Facetten des zweiten Facettenspiegels können entsprechend als virtuelle Facetten ausgebildet sein. Sie können auch entsprechend verlagerbar, insbesondere verkippbar, ausgebildet sein.

Über den zweiten Facettenspiegel und gegebenenfalls über eine nachfolgende, in den Figuren nicht dargestellte Übertragungsoptik, welche beispielsweise drei EUV-Spiegel umfasst, werden die ersten Facetten in das Objektfeld 11ᵢ in der Retikel- beziehungsweise Objektebene 21 abgebildet.

Die einzelnen Beleuchtungskanäle führen zur Beleuchtung des Objektfeldes 11ᵢ mit bestimmten Beleuchtungswinkeln. Die Gesamtheit der Beleuchtungskanäle führt somit zu einer Beleuchtungswinkelverteilung der Beleuchtung des Objektfeldes 11ᵢ durch die Beleuchtungsoptik 17ᵢ. Die Beleuchtungswinkelverteilung wird auch als Beleuchtungssetting bezeichnet.

Bei einer weiteren Ausführung der Beleuchtungsoptik 17ᵢ, insbesondere bei einer geeigneten Lage der Eintrittspupille der Projektionsoptik 14ᵢ, kann auf die Spiegel der Übertragungsoptik vor dem Objektfeld 11ᵢ auch verzichtet werden, was zu einer entsprechenden Transmissionserhöhung für das Nutzstrahlungsbündel führt.

Das Retikel 22ᵢ mit für die Beleuchtungsstrahlung 5 reflektierenden Strukturen ist in der Objektebene 21 im Bereich des Objektfeldes 11ᵢ angeordnet.

Die Projektionsoptik 14ᵢ bildet jeweils das Objektfeld 11ᵢ in das Bildfeld 23ᵢ in der Bildebene 24 ab. In dieser Bildebene 24 ist bei der Projektionsbelichtung der Wafer 25ᵢ angeordnet. Der Wafer 25ᵢ weist eine lichtempfindliche Beschichtung auf, die während der Projektionsbelichtung mit dem Projektionsbelichtungssystem 1 belichtet wird.

Im Folgenden wird eine vorteilhafte Ausführungsform des Beleuchtungssystems 19 beschrieben.

Es wurde erkannt, dass als Hauptstrahlungsquelle 4 vorteilhafterweise ein Freie Elektronen Laser (FEL) oder eine synchrotronbasierte Strahlungsquelle eingesetzt werden kann. Ein FEL skaliert sehr gut, das heißt er kann insbesondere dann besonders ökonomisch betrieben werden, wenn er groß genug ausgelegt wird, um eine Mehrzahl von Scannern 3; mit Beleuchtungsstrahlung 5 zu versorgen. Der FEL kann insbesondere bis zu acht, zehn, zwölf oder auch zwanzig Scanner mit Beleuchtungsstrahlung 5 versorgen.

Andererseits kann es vorteilhaft sein, kompakte und damit kostengünstigere FELs zur Verfügung zu stellen, die jeweils nur einen einzelnen Scanner mit Beleuchtungsstrahlung bedienen. Dies gilt insbesondere wenn in den EUVL-Fabriken nur einzelne Scanner installiert sind. Hauptsächlich auf diese Anwendung zielen die Speicherring-basierten FELs, die Gegenstand dieser Erfindung sind - ohne darauf beschränkt zu sein.

Es kann auch mehr als eine Strahlungsquelle 4 vorgesehen sein.

Eine Anforderung an das Projektionsbelichtungssystem 1 ist, dass die Strahlungsintensität, welche die einzelnen Retikel 22ᵢ erreicht, sowie insbesondere die Strahlungsdosis, welche die Wafer 25ᵢ erreicht, sehr exakt und sehr schnell geregelt werden kann. Die Strahlungsdosis, welche die Wafer 25ᵢ erreicht, soll insbesondere möglichst konstant gehalten werden können.

Schwankungen der auf das Retikel 22; auftreffenden Beleuchtungsstrahlung 5, insbesondere der Gesamtintensität der auf die Retikel 22ᵢ auftreffenden Beleuchtungsstrahlung 5 und damit der auf die Wafer 25ᵢ auftreffende Strahlungsdosis, können auf Intensitätsschwankungen der Hauptstrahlungsquelle und/oder auf geometrische Schwankungen, insbesondere auf Schwankungen der Richtung des von der Hauptstrahlungsquelle 4 emittierten Rohstrahls 6 und/oder Schwankungen des Querschnittsprofils, insbesondere im Bereich der Auskoppeloptik 9, desselben zurückzuführen sein. Schwankungen des Querschnittsprofils können insbesondere auf Divergenzschwankungen des von der Strahlungsquelle 4 emittierten Rohstrahls 6 und/oder des Sammel-Ausgabestrahls 8 zurückzuführen sein.

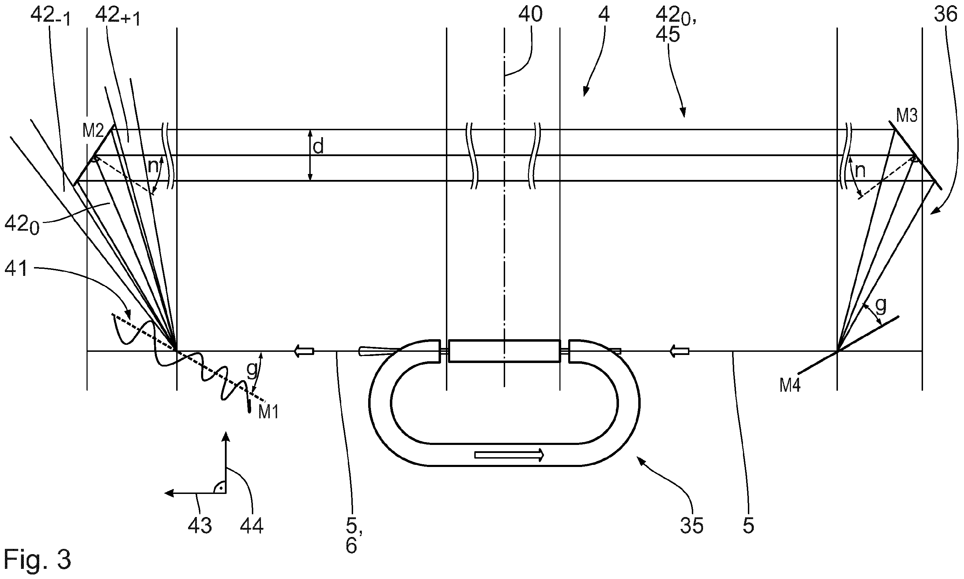

Im Folgenden werden unter Bezugnahme auf die Fig. 3 Details des Strahlungsquellenmoduls 2, insbesondere der Strahlungsquelle 4, beschrieben. Die Strahlungsquelle 4 umfasst den Freie Elektronen Laser 35 (FEL). Der allgemeine Aufbau des kompakten FEL 35 ist bekannt. Stellvertretend wird diesbezüglich auf die Publikationen der Fa. Lyncean Technologies Inc. Michael Feser, https://www.euvlitho.com/2017/P17.pdf und Michael Feser et al, Proc SPIE Vol 10450 1045011-2 (2017) verwiesen. Aus diesen Publikationen ergibt sich auch die Bedeutung der in der Figur 3 nur schematisch dargestellten Bestandteile des FEL 35.

Der FEL 35 emittiert die Beleuchtungsstrahlung 5. Der FEL 35 emittiert insbesondere Beleuchtungsstrahlung 5 mit einer Wellenlänge von höchstens 30 nm, insbesondere mit einer Wellenlänge gemäß der vorhergehenden Beschreibung.

Außerdem umfasst die Strahlungsquelle 4 eine Vorrichtung 36 zur Rückkopplung von Beleuchtungsstrahlung 5 in den FEL 35.

Die Vorrichtung 36 umfasst in Reihenfolge des Strahlengangs der Beleuchtungsstrahlung 5 vier Spiegel M1, M2, M3 und M4.

Die Spiegel M1 bis M4 sind vorzugsweise symmetrisch zu einer Mittelebene 40 angeordnet.

Bei den Spiegeln M1 und M4 handelt es sich um Spiegel für streifenden Einfall (GI-Spiegel, Grazing Incidence Spiegel). Sie werden unter einem Einfallswinkel g (Grazing Angle) von etwa 6° mit Beleuchtungsstrahlung 5 beaufschlagt.

Bei den Spiegeln M2 und M3 handelt es sich um Spiegel für senkrechten Einfall (NI-Spiegel, Normal Incidence Spiegel).

Der Einfallswinkel n beträgt insbesondere etwa 6°.

Auf dem ersten Spiegel M1 ist ein diffraktives optisches Element, insbesondere in Form einer Gitterstruktur 41, angeordnet. Hierbei kann es sich insbesondere um ein geblaztes Gitter handeln. Alternativ hierzu kann als Gitterstruktur 41 ein akustooptisches Element dienen. Für Details eines derartigen akustooptischen Elements sei auf die DE 10 2016 217 426 A1 verwiesen.

Der Spiegel M1 mit der Gitterstruktur 41 bildet ein Mittel zur Auskopplung eines Teils der Beleuchtungsstrahlung 5 aus dem Rohstrahl 6 oder dem Sammel-Ausgabestrahl 8. Es ist insbesondere vorgesehen, lediglich eine bestimmte Beugungsordnung 42 der an der Gitterstruktur 41 gebeugten Beleuchtungsstrahlung 5 zum Spiegel M2 zu leiten, während sämtliche übrigen Beugungsordnungen zu einem oder mehreren der Scanner 3ᵢ weitergeleitet werden.

Der Spiegel mit der Gitterstruktur 41 kann insbesondere als Bestandteil der Strahlformungsoptik 7 und der Auskoppeloptik 9 angesehen werden. Er kann insbesondere einen Bestandteil einer kombinierten Strahlformungs- und Auskoppeloptik bilden.

Vorzugsweise wird die nullte Beugungsordnung 42₀ zum Spiegel M2 geführt. Die erste Beugungsordnung 42₊₁ und die -1. Beugungsordnung 42₋₁ werden zu zwei der Scanner 3ᵢ, 3ⱼ geführt. Alternativ können die höheren Beugungsordnungen durch eine geeignete Optik wieder gesammelt und einem einzelnen Scanner zugeführt werden.

Durch geeignetes Blazen der Gitterstruktur 41 kann die reflektierte Leistung in wenige, vorzugsweise in zwei Beugungsordnungen konzentriert werden.

Vom Spiegel M2 wird der ausgekoppelte Teil der Beleuchtungsstrahlung 5, insbesondere die nullte Beugungsordnung 42₀, zum dritten Spiegel M3 geführt.

Der dritte Spiegel M3 leitet die ausgekoppelte Beleuchtungsstrahlung 5 weiter zum vierten Spiegel M4. Von dort wird die Beleuchtungsstrahlung 5 wieder in Umlaufrichtung des Elektronenstrahles in den FEL 35 eingekoppelt.

Die Richtung, in welcher der Rohstrahl 6 den FEL 35 verlässt, wird als Vorwärtsrichtung 43 bezeichnet. Die Richtung senkrecht hierzu wird als Transversalrichtung 44 bezeichnet. Diese Richtungen sind schematisch in der Figur 3 eingezeichnet.

Der Spiegel M1 ist in Vorwärtsrichtung 43 etwa 10 m vom Ausgang des FEL 35 entfernt angeordnet.

Der Spiegel M2 weist in Vorwärtsrichtung 43 einen Abstand von ebenfalls circa 10 m zum Spiegel M1 auf. Der Abstand zwischen den Spiegeln M1 und M2 in Transversalrichtung 44 beträgt etwa 2 m.

Der Abstand zwischen den Spiegeln M2 und M3 in Vorwärtsrichtung beträgt etwa -52 m.

Der Spiegel M1 ist superpoliert. Er weist insbesondere einen EUV-kompatiblen Passefehler und eine EUV-kompatible Rauheit auf. Der Passefehler des Spiegels M1 beträgt - bei 13,5nm Wellenlänge- höchstens 2,5 nm rms, die Rauheit höchstens 1nm rms. Der Spiegel M4 ist abgesehen von der Gitterstruktur 41 im Wesentlichen identisch zum Spiegel M1 aufgebaut.

Die Spiegel M2 und M3 weisen - bei 13,5nm Wellenlänge - einen Passefehler von höchstens 0,25 nm rms auf.

Die zulässigen Passefehler skalieren typischerweise mit der Wellenlänge, die zulässigen Rauheiten mit dem Quadrat der Wellenlängen.

Sämtliche der Spiegel M1, M2, M3 und M4 können beschichtet sein, um eine möglichst hohe Reflektivität zu erreichen. Die NI-Spiegel M2 und M3 weisen bei 13,5nm Wellenlänge eine Reflektivität von mindestens 60% bevorzugt 70% auf.

Die GI-Spiegel M1 und M4 können eine Beschichtung, insbesondere eine Rutheniumbeschichtung, aufweisen. Hierdurch kann die Reflektivität der NI-Spiegel M1 und M4 bei 13,5nm Wellenlänge auf 94% gesteigert werden.

Material und erreichbare Reflektivität der Beschichtungen hängen von der Belichtungswellenlänge ab. Bei 13,5nm kommen z.B. Mo/Si-basierte Viellagenssrukturen bei 6,8nm eher La/B-basierte Viellagenstrukturen zum Einsatz.

Die vorher genannten Angaben zur Rauheit und zum Passefehler der Spiegel beziehen sich auf Beleuchtungsstrahlung mit einer Wellenlänge von 13,5nm. Bei Beleuchtungsstrahlung mit einer anderen Wellenlänge, beispielsweise von 6,8nm, können die Werte von den vorgehend genannten abweichen. Auch die zulässigen grazing-Winkel hängen von der Wellenlänge der Beleuchtungsstrahlung ab. Sie nehmen mit kleiner werdender Wellenlänge ebenfalls ab.

Beim Auftreffen auf den ersten Spiegel M1 hat die Beleuchtungsstrahlung 5 einen Strahldurchmesser von circa 2 mm. Bei einem Grazing Angle von 0,1rad = 5,7° wird der Strahl auf dem Spiegel M1 in Vorwärtsrichtung 43 auf circa 20 mm aufgeweitet.

Der Strahldurchmesser auf dem Spiegel M2 beträgt etwa 50 mm. Hierdurch wird die thermische Flächenlast erheblich reduziert.

M1 kann als konvexer, in erster Näherung außeraxialer Paraboloidspiegel ausgebildet sein. Er kann auch als Ellipsoid, insbesondere mit der Strahlentaille in einem Fokuspunkt, oder als Hyperboloid oder als Freiformfläche ausgebildet sein. Die Freiformfläche kann insbesondere durch Toroide angenähert werden.

Die Gitterstruktur 41 umfasst Gitterlinien, die entweder normal zur Strahlrichtung oder in Strahlrichtung ausgerichtet sein können. Als Gitterstruktur 41 kann insbesondere ein konisches Gitter mit Linien in Strahlrichtung dienen.

Mit Hilfe der Gitterstruktur wird ein zur Seed-Leitung passender Anteil der Beleuchtungsstrahlung 5 in die nullte Ordnung 42₀, welche in diesem Beispiel die Nutzordnung bildet, ausgekoppelt. Die restlichen Ordnungen 42ᵢ, | i| ≥1, werden zu den Scannern 3ᵢ weitergeleitet.

Wie bereits erwähnt, kann die Gitterstruktur 41 als dynamisches Gitter ausgebildet sein. Dies ermöglicht es, den Anteil der ausgekoppelten Beleuchtungsstrahlung zu steuern, insbesondere zu regeln.

Damit die nicht zum Seed genutzten Beugungsordnungen 42ᵢ, | i| ≥1, unobskuriert weitergeleitet werden können, müssen zwei benachbarte Ordnungen am Spiegel M2 um mindestens den Strahldurchmesser voneinander separiert sein. Dies kann - bei 13.5nm Wellenlänge - erreicht werden, wenn die Gitterstruktur 41 circa 38 Linien pro Millimeter aufweist.

M2 und M3 werden vorzugsweise als Konkavspiegel ausgelegt. Sie können in erster Näherung als außeraxiale Paraboloidspiegel ausgebildet sein. Hierdurch lässt sich ein paralleles Strahlenbündel 45 im Bereich zwischen M2 und M3 erzeugen. Das Strahlenbündel 45 hat einen Durchmesser d von etwa 5 cm.

Der Spiegel M3 nimmt das Strahlenbündel 45 auf und fokussiert es auf den Spiegel M4.

Sämtliche der Spiegel M1, M2, M3 und M4 sind als Viellagen-Spiegel (Multi Layer-Spiegel) mit einer Viellagenstruktur ausgebildet.

Für eine Seeding-Leistung von 50 W wird mit der vorhergehend beschriebenen Rückkopplungsvorrichtung 36 eine Ausgangsleistung des FEL 35 von 1179 W benötigt. Die maximale Thermallast auf den Komponenten der Vorrichtung 36 beträgt in diesem Fall weniger als 180 W/cm². Sie fällt am Spiegel M1 an. Die thermische Last kann durch Verringerung des Grazing-Winkels g und/oder durch Vergrößerung des Abstandes vom Spiegel M1 zum Ausgang des FEL 35 weiter verringert werden.

Vorzugsweise wird der Spiegel M1 aus thermisch hochbelastbaren, insbesondere wärmeleitfähigen Materialien hergestellt. Der Spiegel M1 kann insbesondere aus Siliziumkarbid, Silizium, Kupfer, Ruthenium, Aluminium oder Diamant hergestellt sein. Als Spiegel M1 kann auch ein massiver Rutheniumspiegel dienen. Zur Kühlung des Spiegels M1 kann eine in den Figuren nicht dargestellte Kühleinrichtung vorgesehen sein.

Die Rückkopplungsvorrichtung 36 ist derart ausgebildet, dass der Seedpuls im Undulator parallel zum Elektronenstrahl des FEL 35 läuft. Die unerwünschte Erzeugung hochenergetischer Röntgenstrahlung durch Coherent Inverse Compton Scattering antiparallel laufender Licht- und Elektronenstrahlung, wird hierdurch vermieden.

Durch eine genaue Anpassung der Abstände zwischen den Spiegeln M1, M2, M3 und M4 beziehungsweise durch eine Anpassung der Laufzeit der Beleuchtungsstrahlung 5 in der Rückkopplungsschleife, kann eine Synchronisation mit den im FEL 35 umlaufenden Pulsen erreicht werden.

Im Folgenden werden stichwortartig weitere Details der Vorrichtung 36 und des Betriebs der Strahlungsquelle 4 mit der Vorrichtung 36 beschrieben.

Der mittels der Vorrichtung 36 in den FEL 35 wiedereingekoppelte Puls ist an die Lasermode angepasst. Er ist insbesondere in seinem lateralen Intensitätsprofil identisch zum Puls im FEL 35.

Eine steuerbare Gitterstruktur 41, beispielsweise mit Hilfe eines akustooptischen Elements, ermöglicht eine variable Leistungsrückkopplung.

Es kann vorgesehen sein, die Strahlungsquelle 4 derart auszubilden, dass der FEL 35 während des Betriebs abgeschaltet werden kann. Dies kann dadurch geschehen, dass die Beugungseffizienz in die zum ,seeden' benutzte Beugungsordnung, insbesondere in die 0.te Beugungsordnung unterdrückt wird. Dies kann beispielsweise durch Abschalten der Steuerspannung an dem akustooptischen Element geschehen. Bei einem statischen Gitter kann dies durch Verschieben oder gänzlichem Entfernen des Gitters im bzw. aus dem Strahlengang erreicht werden. Durch Beeinflussung der Amplitude des Gittes lassen sich die Beugungseffizienzen direkt beeinflussen.

Durch Beeinflussung der Gitterperiode des z.B. akustooptischen Elementes können Beugungswinkel und durch Überstrahlungsverluste an den nachfolgenden Spiegeln sowie Modenmissanpassung eingekoppelte Leistungen und die FEL-Leistung gesteuert werden.

Durch diese Maßnahmen kann basierend auf geeigneten Feedback- oder Feedforward-Informationen dann z.B. eine Dosiskontrolle auf Retikel- oder Waferebene realisiert werden.

Die Strahlungsquelle 4 gemäß der vorhergehenden Beschreibung kann auch anstelle des Projektionsbelichtungssystems 1 für ein Metrologie-System verwendet werden.

## Patentansprüche

1. Strahlungsquelle (4) geeignet für ein Projektionsbelichtungssystem (1) oder ein Metrologiesystem aufweisend
1.1. einen Freie Elektronen Laser, FEL, (35), welcher Beleuchtungsstrahlung mit einer Wellenlänge von höchstens 30 nm emittiert und
1.2. eine Vorrichtung (36) eingerichtet zur Rückkopplung von emittierter Beleuchtungsstrahlung (5) in den FEL (35) aufweisend
1.2.1.mindestens eine optische Komponente (M1) eingerichtet zur Auskopplung von Beleuchtungsstrahlung (5) aus einem Strahlengang und
1.2.2.mindestens eine optische Komponente zur Einkopplung zumindest eines Anteils der ausgekoppelten Beleuchtungsstrahlung (5) als Seed-Puls in den FEL (35),
1.3. wobei die mindestens eine optische Komponente zur Auskopplung von Beleuchtungsstrahlung (5) aus dem Strahlengang ein diffraktives optisches Element (41) aufweist.

2. Strahlungsquelle (4) gemäß Anspruch 1, wobei die mindestens eine optische Komponente zur Auskopplung von Beleuchtungsstrahlung (5) aus dem Strahlengang und/oder die mindestens eine optische Komponente zur Einkopplung von Beleuchtungsstrahlung (5) in den FEL (35) jeweils einen Spiegel (M1, M4) für streifenden Einfall (GI-Spiegel; grazing incidence Spiegel) aufweisen.

3. Strahlungsquelle (4) gemäß einem der vorhergehenden Ansprüche, wobei das diffraktive optische Element (41) ansteuerbar ausgebildet ist.

4. Strahlungsquelle (4) gemäß einem der vorhergehenden Ansprüche, wobei das diffraktive optische Element (41) Linien senkrecht zur Strahlrichtung aufweist

5. Strahlungsquelle (4) gemäß einem der vorhergehenden Ansprüche, wobei das diffraktive optische Element (41) Linien parallel zur Strahlrichtung aufweist.

6. Strahlungsquelle (4) gemäß Anspruch 2, wobei mindestens einer der Spiegel (M1, M4) für streifenden Einfall hergestellt ist aus Siliziumcarbid (SiC), Silizium (Si), Kupfer (Cu), Ruthenium (Ru), Aluminium(Al) oder Diamant oder Bestandteile dieser Stoffe oder deren Verbindungen oder Legierungen aufweist.

7. Strahlungsquelle (4) gemäß einem der vorhergehenden Ansprüche, wobei die mindestens eine optische Komponente mit dem diffraktiven optischen Element (41) eine Kühleinrichtung aufweist.

8. Strahlungsquelle (4) gemäß einem der vorhergehenden Ansprüche wobei sie zwei Spiegel (M1, M4) für streifenden Einfall (grazing incidence) und zwei Spiegel (M2, M3) für senkrechten Einfall (normal incidence) aufweist.

9. Vorrichtung (36) eingerichtet zur Rückkopplung von emittierter Beleuchtungsstrahlung (5) in einen Freie Elektronen Laser, FEL, (35) aufweisend
9.1. mindestens eine optische Komponente (M1) eingerichtet zur Auskopplung von Beleuchtungsstrahlung (5) aus einem Strahlengang und
9.2. mindestens eine optische Komponente eingerichtet zur Einkopplung zumindest eines Anteils der ausgekoppelten Beleuchtungsstrahlung (5) als Seed-Puls in den FEL (35),
9.3. wobei die mindestens eine optische Komponente zur Auskopplung von Beleuchtungsstrahlung (5) aus dem Strahlengang ein diffraktives optisches Element (41) aufweist.

10. Verfahren zur Betrieb eines Freie Elektronen Lasers, FEL, umfassend die folgenden Schritte:
10.1. Bereitstellen einer Strahlungsquelle (4) gemäß einem der Ansprüche 1 bis 8,
10.2. Erzeugen von Beleuchtungsstrahlung (5) mittels des FEL (35),
10.3. Auskoppeln eines Teils der vom FEL (35) erzeugten Beleuchtungsstrahlung (5) aus dem Strahlengang,
10.4. Wiedereinkoppeln zumindest eines Anteils der ausgekoppelten Beleuchtungsstrahlung (5) als Seed-Puls in den FEL (35).

11. Verfahren gemäß Anspruch 10, wobei eine Ansteuerung des diffraktiven optischen Elements (41) zur Steuerung der zu einem Bildfeld (23e) geführten Beleuchtungsstrahlung (5) vorgesehen ist.

12. Beleuchtungssystem (19) für ein Projektionsbelichtungssystem (1) oder ein Metrologiesystem aufweisend eine Strahlungsquelle (4) gemäß einem der Ansprüche 1 bis 8.

13. Projektionsbelichtungssystem (1) für die Mikrolithographie aufweisend
13.1. ein Beleuchtungssystem (19) gemäß Anspruch 12 und
13.2. mindestens eine Projektionsoptik (14i) zur Abbildung eines Objektfeldes (11i) in ein Bildfeld (23i).

14. Metrologiesystem aufweisend ein Beleuchtungssystem (19) gemäß Anspruch 12.

15. Verfahren zur Herstellung eines mikro- oder nanostrukturierten Bauelements umfassend die folgenden Schritte
15.1. Bereitstellen eines Projektionsbelichtungssystems (1) gemäß Anspruch 13,
15.2. Anordnen eines Retikels (22ᵢ) in einem Objektfeld (11ᵢ),
15.3. Beaufschlagen des Retikels (22ᵢ) mit Beleuchtungsstrahlung (5),
15.4. Abbilden des Retikels (22ᵢ) auf eine lichtempfindliche Schicht eines Wafers (25ᵢ) im Bildfeld (23ᵢ) der Projektionsoptik (14ᵢ),
15.5. Entwickeln der lichtempfindlichen Schicht auf dem Wafer (25i).

16. Bauelement hergestellt nach einem Verfahren gemäß Anspruch 15, wobei das Bauelement ein Projektionsbelichtungssystem gemäß Anspruch 13 enthält.

## Claims

1. Radiation source (4) suitable for a projection exposure system (1) or a metrology system comprising
1.1. a free electron laser, FEL, (35), which emits illumination radiation having a wavelength of at most 30 nm and
1.2. a device (36) designed for feeding back emitted illumination radiation (5) to the FEL (35) comprising
1.2.1.at least one optical component (M1) designed for coupling out illumination radiation (5) from a beam path, and
1.2.2.at least one optical component for coupling at least one portion of the coupled-out illumination radiation (5) as seed pulse into the FEL (35),
1.3. wherein the at least one optical component for coupling out illumination radiation (5) from the beam path comprises a diffractive optical element (41).

2. Radiation source (4) according to Claim 1, wherein the at least one optical component for coupling out illumination radiation (5) from the beam path and/or the at least one optical component for coupling illumination radiation (5) into the FEL (35) comprise(s) in each case a grazing incidence mirror (M1, M4) (GI mirror).

3. Radiation source (4) according to either of the preceding claims, wherein the diffractive optical element (41) is embodied as drivable.

4. Radiation source (4) according to any of the preceding claims, wherein the diffractive optical element (41) has lines perpendicular to the beam direction.

5. Radiation source (4) according to any of the preceding claims, wherein the diffractive optical element (41) has lines parallel to the beam direction.

6. Radiation source (4) according to Claim 2, wherein at least one of the grazing incidence mirrors (M1, M4) is produced from silicon carbide (SiC), silicon (Si), copper (Cu), ruthenium (Ru), aluminum (Al) or diamond or constituents of these substances or compounds or alloys thereof.

7. Radiation source (4) according to any of the preceding claims, wherein the at least one optical component having the diffractive optical element (41) comprises a cooling unit.

8. Radiation source (4) according to any of the preceding claims, wherein it comprises two grazing incidence mirrors (M1, M4) and two normal incidence mirrors (M2, M3).

9. Device (36) designed for feeding back emitted illumination radiation (5) to a free electron laser, FEL, (35) comprising
9.1. at least one optical component (M1) designed for coupling out illumination radiation (5) from a beam path, and
9.2. at least one optical component designed for coupling at least one portion of the coupled-out illumination radiation (5) as seed pulse into the FEL (35),
9.3. wherein the at least one optical component for coupling out illumination radiation (5) from the beam path comprises a diffractive optical element (41).

10. Method for operating a free electron laser, FEL, comprising the following steps:
10.1. providing a radiation source (4) according to any of Claims 1 to 8,
10.2. generating illumination radiation (5) by means of the FEL (35),
10.3. coupling out a part of the illumination radiation (5) generated by the FEL (35) from the beam path,
10.4. coupling at least one portion of the coupled-out illumination radiation (5) as seed pulse into the FEL (35) again.

11. Method according to Claim 10, wherein provision is made for driving the diffractive optical element (41) for controlling the illumination radiation (5) guided to an image field (23e).

12. Illumination system (19) for a projection exposure system (1) or a metrology system comprising a radiation source (4) according to any of Claims 1 to 8.

13. Microlithographic projection exposure system (1) comprising
13.1. an illumination system (19) according to Claim 12 and
13.2. at least one projection optical unit (14i) for imaging an object field (11i) into an image field (23i).

14. Metrology system comprising an illumination system (19) according to Claim 12.

15. Method for producing a micro- or nanostructured component comprising the following steps:
15.1. providing a projection exposure system (1) according to Claim 13,
15.2. arranging a reticle (22ᵢ) in an object field (11ᵢ),
15.3. causing illumination radiation (5) to impinge on the reticle (22ᵢ),
15.4. imaging the reticle (22ᵢ) onto a light-sensitive layer of a wafer (25ᵢ) in the image field (23ᵢ) of the projection optical unit (14ᵢ),
15.5. developing the light-sensitive layer on the wafer (25ᵢ).

16. Component produced according to a method according to Claim 15, wherein the component contains a projection exposure system according to Claim 13.

## Revendications

1. Source de rayonnement (4) adaptée à un système d'éclairement par projection (1) ou à un système de métrologie, ladite source de rayonnement comportant
1.1. un laser à électrons libres FEL (35) qui émet un rayonnement d'éclairage d'une longueur d'onde de 30 nm maximum et
1.2. un dispositif (36) conçu pour renvoyer par couplage le rayonnement d'éclairage émis (5) dans le FEL (35),
1.2.1. au moins un composant optique (M1) conçu pour délivrer par couplage le rayonnement d'éclairage (5) en sortie d'un trajet de faisceau et
1.2.2. au moins un composant optique destiné à injecter par couplage dans le FEL (35) au moins une partie du rayonnement d'éclairage (5), délivré en sortie par couplage, sous la forme d'une impulsion d'amorçage,
1.3. l'au moins un composant optique destiné à délivrer par couplage le rayonnement d'éclairage (5) en sortie du trajet de faisceau comportant un élément optique diffractif (41).

2. Source de rayonnement (4) selon la revendication 1, l'au moins un composant optique destiné à délivrer par couplage le rayonnement d'éclairage (5) en sortie du trajet de faisceau et/ou l'au moins un composant optique destiné à injecter par couplage le rayonnement d'éclairage (5) dans le FEL (35) comportant chacun un miroir (M1, M4) à incidence rasante (miroir GI ; miroir Grazing Incidence).

3. Source de rayonnement (4) selon l'une des revendications précédentes, l'élément optique diffractif (41) étant conçu pour être commandable

4. Source de rayonnement (4) selon l'une des revendications précédentes, l'élément optique diffractif (41) comportant des lignes perpendiculaires à la direction du faisceau.

5. Source de rayonnement (4) selon l'une des revendications précédentes, l'élément optique diffractif (41) comportant des lignes parallèles à la direction du faisceau.

6. Source de rayonnement (4) selon la revendication 2, au moins un des miroirs (M1, M4) à incidence rasante étant réalisé à partir de carbure de silicium (SiC), de silicium (Si), de cuivre (Cu), de ruthénium (Ru), d'aluminium (Al) ou de diamant ou de composants de ces substances ou de leurs composés ou alliages.

7. Source de rayonnement (4) selon l'une des revendications précédentes, l'au moins un composant optique pourvu de l'élément optique diffractif (41) comportant un module de refroidissement.

8. Source de rayonnement (4) selon l'une des revendications précédentes, **caractérisée en ce qu'**elle comporte deux miroirs (M1, M4) à incidence rasante (grazing incidence) et deux miroirs (M2, M3) à incidence perpendiculaire (normal incidence).

9. Dispositif (36) conçu pour renvoyer par couplage le rayonnement d'éclairage émis (5) dans un laser à électrons libres FEL (35), ledit dispositif comportant
9.1. au moins un composant optique (M1) conçu pour délivrer par couplage le rayonnement d'éclairage (5) en sortie d'un trajet de faisceau et
9.2. au moins un composant optique conçu pour injecter par couplage dans le FEL (35) au moins une partie du rayonnement d'éclairage (5), délivré en sortie par couplage, sous la forme d'une impulsion d'amorçage,
9.3. l'au moins un composant optique destiné à délivrer par couplage le rayonnement d'éclairage (5) en sortie du trajet du faisceau comportant un élément optique diffractif (41).

10. Procédé de fonctionnement d'un laser à électrons libres FEL, ledit procédé comprenant les étapes suivantes :
10.1. fournir une source de rayonnement (4) selon l'une des revendications 1 à 8,
10.2. générer un rayonnement d'éclairage (5) à l'aide du FEL (35),
10.3. délivrer par couplage une partie du rayonnement d'éclairage (5) généré par le FEL (35) en sortie du trajet du faisceau,
10.4. réinjecter par couplage dans le FEL (35) au moins une partie du rayonnement d'éclairage (5), délivré en sortie par couplage, sous la forme d'une impulsion d'amorçage.

11. Procédé selon la revendication 10, une commande de l'élément optique diffractif (41) étant prévue pour commander le rayonnement d'éclairage (5) guidé vers un champ d'image (23e).

12. Système d'éclairage (19) destiné à un système d'éclairement par projection (1) ou un système de métrologie, ledit système d'éclairage comportant une source de rayonnement (4) selon l'une des revendications 1 à 8.

13. Système d'éclairement par projection (1) destiné à la microlithographie, ledit système d'éclairement par projection comportant
13.1. un système d'éclairage (19) selon la revendication 12 et
13.2. au moins une optique de projection (14i) destinée à reproduire un champ objet (11i) dans un champ d'image (23i).

14. Système de métrologie comportant un système d'éclairage (19) selon la revendication 12.

15. Procédé de réalisation d'un composant micro-structuré ou nano-structuré, ledit procédé comprenant les étapes suivantes
15.1. fournir un système d'éclairement par projection (1) selon la revendication 13,
15.2. disposer un réticule (22ᵢ) dans un champ objet (11ᵢ),
15.3. appliquer un rayonnement d'éclairage (5) au réticule (22ᵢ),
15.4. reproduire le réticule (22ᵢ) sur une couche photosensible d'une plaquette de semi-conducteur (25ᵢ) dans le champ d'image (23ᵢ) de l'optique de projection (14ᵢ),
15.5. développer la couche photosensible sur la plaquette de semi-conducteur (25ᵢ).

16. Composant réalisé selon un procédé selon la revendication 15, le composant contenant un système d'éclairement par projection selon la revendication 13.
